# EUROPÄISCHE PATENTSCHRIFT

(11) **EP 0 825 655 B1**
(45) Veröffentlichungstag und Bekanntmachung des Hinweises auf die Patenterteilung: **20.10.2004**
(21) Anmeldenummer: 97114390.4
(22) Anmeldetag: 20.08.1997
(51) Int. Cl.: H01L 37/02

(54) **Ferroelektrisches Bauelement und Verfahren zur Herstellung von ferroelektrischen Bauelement-Anordnungen**
Ferroelectric device and method for fabricating a ferroelectric device arrangement
Dispositif ferroélectrique et procédé de fabrication d'un dispositif assemblé ferroélectrique

(30) Priorität: 23.08.1996 DE 19634151
(43) Veröffentlichungstag der Anmeldung: 25.02.1998
(73) Patentinhaber: SIEMENS AKTIENGESELLSCHAFT, 80333 München (DE)
(72) Erfinder: Bruchhaus, Rainer, Dr., 80997 München (DE); Pitzer, Dana, 85716 Unterschleissheim (DE)

(56) Entgegenhaltungen:
- EP-A- 0 640 815

## Beschreibung

Die Erfindung betrifft ein ferroelektrisches Bauelement, das eine Trägersubstanz, eine untere Elektrode, eine ferroelektrisch aktive Schicht, eine Schicht aus isolierendem Material und eine obere Elektrode umfaßt. Daneben wird ein Verfahren zur Herstellung von ferroelektrischen Bauelement-Anordnungen, wie Pyrodetektor-Arrays angegeben.

Bei der Herstellung von - beispielsweise- Pyrodetektor-Arrays, (d.h. Anordnungen mehrerer, auf einem gemeinsamen Substrat integrierter Pyrodetektoren) die zusammen ein Wärmebild einer IR-Quelle, wie einem Menschen, erzeugen können, existiert bei der elektrischen Verschaltung der einzelnen Pyrodetektoren ein Isolationsproblem, wenn eine hohe Packungsdichte auf dem Array angestrebt wird. Damit ein Kurzschluß vermieden wird, muß die untere Elektrode komplett von der oberen isoliert sein. Normalerweise würde man dieses Problem umgehen, indem man die untere Elektrode durch Ätzen derart strukturiert, daß keine Überlappungsbereiche mit der oberen bestehen bleiben. Jedoch wird üblicher - aber nicht notwendigerweise die untere Elektrode nicht vor der oberen Elektrode strukturiert, weil die ferroelektrisch aktive Schicht am besten über einer ganzflächigen und, z.B. aus Platin mit einer bestimmten Oberfläche, bestehenden Elektrodenschicht erzeugt wird. Die Strukturierung der unteren Elektrodenschicht unter Ausbildung der Elektroden und der zugehörigen Anschlußleitungen ist daher erst nach Erzeugen und Strukturieren der ferroelektrisch aktiven Schicht optimal, so daß Bereiche der Kanten der unteren Elektroden vor dem Erzeugen der oberen Elektroden, bzw. deren Anschlußleitungen, mit Isolationsmaterial abgedeckt werden müssen. Dies erfordert zumindest immer einen zusätzlichen Arbeitsschritt, der üblicherweise (z.B. bei der Isolierung mit SiO₂ oder Si-Nitrid) mit Temperaturerhöhung und kurzzeitigem Einbringen des Bauelements in reduzierende, H₂-haltige Atmosphäre verbunden ist. Dabei kann die ferroelektrische Aktivität des Bauelements beschädigt werden, weil der Selbstpolungseffekt der aktiven Schicht zerstört werden kann.

Aus der EP 0 640 815 A1 ist ein ferroelektrisches Bauelement der eingangs genannten Art bekannt. Die Schicht aus isolierendem Material zur Isolierung der unteren Elektrode besteht aus einem organischen Harz. Bekannt ist außerdem, für die Isolation ferroelektrisch aktives Material zu nehmen. Nachteilig dabei ist, daß zusätzliche pyroelektrisch aktive Kapazitäten entstehen, die das Meßsignal oder Wärmebild verfälschen können.

Es wird demnach nach Lösungen gesucht, die untere Elektrodenschicht eines Pyrodetektors wirksam und kostengünstig vor dem Aufbringen der oberen Elektrode auf der ferroelektrisch aktiven Schicht zu isolieren.

Aufgabe der vorliegenden Erfindung ist es daher, ein ferroelektrisch aktives Bauelement mit oxidischen Materialien für die isolierende Schicht und ein Verfahren zur Herstellung von ferroelektrischen Bauelementen zur Verfügung zu stellen, bei dem die untere Elektrode, nach Aufbringen der ferroelektrischen Schicht, und vor dem Aufbringen der oberen Elektrode, kostengünstig, ohne Temperaturerhöhung und ohne Anwendung reduzierender Gase wie H₂, isoliert wird.

Gegenstand der vorliegenden Erfindung ist ein ferroelektrischen Bauelement, das eine Trägersubstanz, eine untere Elektrode, eine ferroelektrisch aktive Schicht, eine Schicht aus isolierendem Material und eine obere Elektrode umfaßt, wobei die Schicht aus isolierendem Material ein Oxid, ausgewählt aus der Reihe der zwei- und dreiwertigen anorganischen Oxide oder Mischoxide, ist.

Außerdem ist Gegenstand der Erfindung ein Verfahren zur Herstellung von ferroelektrischen Bauelementen, bei dem nacheinander folgende Schichten auf ein Substrat aufgebracht werden:
- eine untere Elektrode,
- auf die unter Elektrode eine Ferroelektrisch aktive Schicht
- auf die Ferroelektrisch aktive Schicht ein Material, das als Untergrund für ein Lift-Off-Verfahren geeignet ist, wobei dieses Material so strukturiert wird, daß die Stellen, die gegenüber der oberen Elektrode zu isolieren sind, frei von dem Material bleiben,
- über die Oberfläche des soweit bestehenden, also unfertigen, Bauelements eine Schicht aus isolierendem Material, das nach einem darauffolgenden Lift-Off-Verfahrensschritt nur an den Stellen des unfertigen Bauelements, an denen zuvor kein Lift-Off-Untergrund-Material war, bestehen bleibt und schließlich
- eine obere Elektrode.

Weitere vorteilhafte Ausgestaltungen der Erfindung ergeben sich aus den Unteransprüchen, der Beschreibung, den Figuren und den Erläuterungen dazu.

Bevorzugt sind die Schichten aus isolierendem Material Oxide oder Mischoxide der Elemente Al³⁺, Mg²⁺ und Ti^{2+/4+}. Die Oxide können in reiner Form oder als beliebige Mischungen in der Isolationsschicht enthalten sein. Der strukturelle Aufbau der Oxide ist ebenfalls beliebig.

Bei einer bevorzugten Ausführungsform des Verfahrens wird das isolierende Material durch Sputtern oder Aufdampfen auf der Oberfläche des unfertigen Bauelements, das zumindest ein Substrat, eine untere Elektrode, eine ferroelektrisch aktive Schicht, eine Schicht aus strukturiertem, und als Untergrund für ein Lift-Off-Verfahren geeigneten, Material umfaßt, aufgebracht.

Vorteilhaft ist die Ausführungsform bei der die ferroelektrisch aktive Schicht Bleizirkonat-Titanat (PZT) ist.

Nach einer weiteren, vorteilhaften Ausgestaltung der Erfindung ist das Material, das als Untergrund für das Lift-Off-Verfahren dient, ein Photolack.

Das Verfahren wird bevorzugt auf die Herstellung von Pyrodetektorarrays oder Kondensatorarrays angewendet.

Als Reihe der zwei- und dreiwertigen anorganischen Oxide" werden alle Oxide von Metallen der II. und III. Hauptgruppe im Periodensystem verstanden, sowie alle Oxide der Übergangs-elemente und der nicht radioaktiven Lanthanoide, die in den Oxidationsstufen +2" und/oder +3" vorliegen. Insbesondere sind die Elementoxide der Elemente Mg, Ca, Sr, Ba, Al, Ga, In, Ge, Pb, Ti, Sc, Zr, V, Cr, Mn, Mo, Fe, Co, Ni, Ru, Rh, Pd, Zn, Cu, Au und Ag bevorzugt.

Als Mischoxide" der oben genannten Reihe von Oxiden werden hier, unabhängig vom fachspezifischen Gebrauch des Terms, alle Verbindungen bezeichnet, die sich aus zwei oder mehr der genannten Oxide zusammensetzen, unabhängig von der stöchiometrischen oder (Mol-)prozentualen Zusammensetzung oder Kristallstruktur, in der die Verbindung vorliegt oder vorliegen kann.

Als ferroelektrisches Bauelement" werden Bauelemente, wie beispielsweise ein Pyrodetektor bezeichnet. Diese umfassen zumindest eine aktive Schicht aus ferroelektrischem Material, welche beidseitig mit Elektroden versehen und auf einem Trägermaterial oder Substrat aufgebracht ist. Darüber hinaus können noch andere Schichten, wie z.B. Schichten aus der integrierten Si-Technik für Transistoren, Widerstände, usw. die Ansteuerschaltungen und Ausleseschaltungen benötigen, enthalten sein.

Als ferroelektrische Materialien werden beispielsweise bleihaltige Perowskite aus der Klasse der Bleititanate, vorzugsweise Bleizirkonat-Titanat, PZT genannt, verwendet. Die für die Ferroelektrizität erforderliche dauerhafte Polarisierung der aktiven Schicht kann durch Einbringen dieser Schicht in ein starkes elektrisches Feld erzeugt werden oder stellt sich beim Aufwachsen des Ferroelektrikums von selbst ein.

Die ferroelektrisch aktive Schicht eines Pyrodetektors oder Bauelements reagiert auf die Bestrahlung mit infraroten Strahlen, d.h. auf Erwärmung, mit dem Aufbau einer, an den Elektroden ablesbaren, elektrischen Spannung. Dabei wird die Übertragung des Wärmesignals in ein elektrisches Signal um so unmittelbarer und deshalb unverfälschter erfolgen, je geringer die Wärmekapazität der das pyroelektrische Element tragenden Schichten des Pyrodetektors ist. Die Minimierung der Wärmekapazität geschieht, hauptsächlich aber nicht ausschließlich, durch Rückätzen des Substrats auf dem das Detektorelement aufgebaut wird.

Die ferroelektrisch aktive Schicht eines Pyrodetektors ist üblicherweise zwischen einer ersten unteren und einer zweiten oberen Elektrode angeordnet. Bei der Herstellung wird also die ferroelektrisch aktive Schicht auf der unteren Elektrode aufgebracht. Im allgemeinen wird die ferroelektrisch aktive Schicht, also beispielsweise die PZT-Schicht, bevorzugt über ganzflächigen und z.B. aus Platin, Iridium oder Ruthenium bestehenden Elektrodenschicht erzeugt werden, weil zum Aufbringen der aktiven Schicht eine geordnete Oberfläche, wie die einer Platinelektrode, nötig ist, damit das Ferroelektrikum PZT bei möglichst niedrigen Temperaturen in der notwendigen Perowskitphase entsteht. Eine Strukturierung der unteren Elektrodenschicht unter Ausbildung der unteren Elektroden und der dazugehörigen Anschlußleitungen ist daher in der Regel erst nach dem Erzeugen und nach dem Strukturieren der ferroelektrisch aktiven Schicht möglich, so daß stets zumindest Bereiche der Kanten der unteren Elektroden vor dem Erzeugen der oberen Elektrode bzw. deren Anschlußleitungen mit isolierendem Material abgedeckt werden müssen.

Als Substrat" werden die übliche Trägermaterialien für Pyrodetektoren und andere Bauelemente verwendet und insbesondere monokristalline Halbleiterkörper und besonders bevorzugt Siliziumhalbleiterkörper.

Als untere Elektrode" sowie als Material für deren elektrische Anschlußleitungen werden vorteilhafterweise Platinmaterialien und insbesondere reines Platin verwendet. Andere Beispiele für mögliche Elektrodenmaterialien sind Ruthenium, Iridium oder deren Oxide. Eine Platinschicht läßt sich beipielsweise mit einer (200)-orientierten Oberfläche herstellen, die als Unterlage beim Erzeugen einer ferroelektrisch aktiven Schicht eine dafür geeignete (200)-Orientierung der ferroelektrisch aktiven Schicht begünstigt. Mit dieser Orientierung wird bereits beim Herstellen mit einem geeigneten Verfahren, z.B. der Sputtertechnik, eine Polarisierung des ferroelektrischen Materials erreicht, die sich parallel zur C-Achse und vertikal zur Substratoberfläche ausbildet. Mit dieser Orientierung werden die besten ferroelektrischen Eigenschaften erzielt.

Erfindungsgemäß sind natürlich auch Bauelemente mit ferroelektrisch aktiven Schichten, die nicht in der optimalen (200) Orientierung vorliegen, (sondern bei denen z.B. die (111)-Textur eher begünstigt ist) mitumfaßt, weil der technische Aufwand zur Realisierung der (200)-orientierten unteren Elektrode nicht in allen Fällen lohnt.

Als "obere Elektrode" wird bevorzugt eine Chrom-Nickel-Schicht aufgebracht. Alternativen zu diesem Material sind reine Chrom oder reine Nickel Schichten.

Als "Lift-Off-Verfahren" wird eine Art Batik-Verfahren bezeichnet, bei dem vor Aufbringung der nächsten gewünschten Schicht eine Zwischenschicht auf bestimmte Bereiche des Substrats oder der Anordnung aufgebracht wird und zwar derart, daß diese Bereiche vor der darauffolgenden Schicht geschützt bleiben, d.h., daß die nächste Schicht nicht auf diesen Bereichen der Oberfläche haften bleiben sollen. Es handelt sich also bei der "Lift-Off-Untergrund-Materials-Schicht" um eine Art Schutzschicht, die samt der darauffolgenden Schicht leicht wieder entfernt werden kann.

Erfindungsgemäß wird dabei bevorzugt, aber nicht ausschließlich, ein Photolack benutzt, der auf die ferroelektrisch aktive Schicht, die Teile der unteren Elektrode, die nicht vollständig von der ferroelektrisch aktiven Schicht bedeckt sind und auf die noch unbedeckte Oberfläche des Substrats aufgebracht und dann so strukturiert wird, daß die zu isolierenden Teile frei von Photolack bleiben. Danach wird die gesamte Oberfläche des unfertigen Bauelements mit isolierendem Material überzogen. Neben dem genannten Photolack sind auch Hartmasken, z.B. aus Titan oder Siliziumdioxid, einsetzbare Lift-Off-Untergrund-Materialien.

Als isolierendes Material werden bei dem Verfahren alle zwei- und dreiwertigen anorganischen Oxide und/oder Mischoxide, bevorzugt Aluminiumoxid, Magnesiumoxid oder Titanoxid, benutzt, wobei diese isolierenden Materialien entweder durch das Sputtern der Oxide oder das Aufdampfen der Isolationsschicht aufgebracht werden können. Besonders vorteilhaft ist dabei, daß gegenüber dem Stand der Technik eine reduzierende Atmosphäre beim Aufsputtern der Isolatoren wegfällt, weil beim Lift-Off-Verfahren die Verwendung von Oxiden oder Mischoxiden, wie Magnesium- und/oder Aluminium- und/oder Titanoxid, die naturgemäß in oxidierender und nicht in reduzierender Atmosphäre aufgebracht werden, als Material für die isolierende Schicht geeignet sind. Besonders vorteilhaft ist die Aufbringung des Isolators durch Sputtern der Oxide in Schutzgas- und besonders bevorzugt in Argon-Atmosphäre.

Ein weiterer Vorteil des Lift-Off-Verfahrens ist, daß das isolierende Material ohne Temperaturerhöhung, d.h. aufgrund der thermischen Empfindlichkeit der Hart- oder Lackmaske sogar bei sehr niedrigen Temperaturen, aufgebracht werden muß. Das bedeutet, daß der Selbstpolungseffekt der ferroelektrisch aktiven Schicht (der für die Wirksamkeit und Effektivität dieser Schicht ausschlaggebend ist) nicht wie bisher durch Temperaturerhöhung bei der Aufbringung des isolierenden Materials gefährdet wird.

Das erfindunsgemäße Verfahren kann Teil der Herstellung von IR-Detektor-Arrays mit ferroelektrischen Dünnschichten sein, es kann sich aber auch allgemein auf die Herstellung einer Anordnung von mehreren, z. B. in Serie oder parallel geschalteter - nicht zwangsweise aber vorzugsweise - ferroelektrischer Bauelemente, die zwei voneinander zu isolierende Elektroden mit Anschlußleitungen haben, beziehen. Dazu werden regelmäßig mehrere ferroelektrische Bauelemente oder IR-Detektoren auf einem gemeinsamen Substrat angeordnet. Jedes der Bauelemente besitzt einen aktiven Bereich aus einem ferroelektrischen Material, beispielsweise aus PZT, der zwischen einer ersten unteren und einer zweiten oberen Elektrode angeordnet ist. Jedes der Bauelemente besitzt elektrische Anschlußleitungen und kann, außer bei parallel oder serieller Verschaltung einzeln elektrisch angesprochen werden. Die ferroelektrischen Bauelemente sind auf dem Substrat bevorzugt regelmäßig angeordnet, beispielsweise in Form einer Reihe, in Form von mehreren Reihen oder in Form eines regelmäßigen Rasters. Dabei sind sie vorzugsweise, aber nicht unbedingt, gleichmäßig über einen "Bauelementbereich", d.h. einen Bereich der mit Bauelementen besetzt ist, auf dem Substrat verteilt.

Eine möglichst dichte Anordnung wird allgemein bevorzugt, weil sie die Integrationsdichte der Bauelemente auf dem Substrat erhöht, sie erlaubt damit das Herstellen leistungsfähigerer Bauelement-Anordnungen oder -Arrays und ist, wegen der kompakten Bauform, außerdem materialsparend. Ist das ferroelektrische Bauelement beispielsweise ein Pyrodetektor, so führt eine dichtere Anordnung der Bauelemente zur Erhöhung der Auflösung des mit dem Array meßbaren Wärembildes. Falls das Array oder die Anordnung der Bauelemente eine Kondensatoranordnung zur Informationsspeicherung ist, so wird die Speicherdichte und damit die Speicherkapazität der Anordnung durch eine möglichst dichte Packung der einzelnen Bauelemente innerhalb der Anordnung erhöht.

Die ferroelektrisch aktiven Bereiche der ferroelektrischen Bauelemente sind gegeneinander elektrisch und vorzugsweise auch thermisch isoliert. Dazu ist rund um den aktiven Bereich eines jeden Bauelementes die aktive Schicht bis auf das Substrat soweit entfernt, daß nur noch an einer Stelle Reste der Isolierung unterhalb der Anschlußleitung für die obere Elektrode verbleiben. Die elektrische Isolierung der Bauelemente gegeneinander ist für jede Art von elektrischen Bauelementen erforderlich oder zumindest von Vorteil. Die thermische Isolierung der ferroelektrischen Bauelemente dagegen ist nur für die pyroelektrischen Bauelemente erforderlich, um Wärmebrücken zwischen den einzelnen (pyroelektrischen) Bauelementen zu vermeiden. Nur so wird ein "Übersprechen" zwischen den einzelnen Bauelementen, also die Beeinflussung eines Bauelementes durch die in einem benachbarten, angesprochenen Bauelement absorbierte Wärmemenge, vermieden.

Bei der Herstellung solcher Arrays werden sämtliche Schichten zunächst ganzflächig erzeugt und in einem späteren Schritt strukturiert. Die Strukturierung einer Schicht kann dabei unmittelbar nach deren Erzeugung erfolgen, oder erst nach dem Erzeugen mehrerer Schichtebenen mittels einer Reihe von Strukturierungsschritten oder in einem gemeinsamen Strukturierungsschritt. Wie bereits erwähnt ist dabei von Vorteil, wenn zumindest die Strukturierung der unteren Elektrodenschicht erst nach Aufbringung der ferroaktiven Schicht passiert.

Als "Strukturieren" wird der Verfahrensschritt bezeichnet, in dem von einer komplett aufgetragenen Schicht die Teile wieder entfernt werden, die mit dieser Oberfläche nicht geplant waren. Es können so Kanäle, Rinnen, Nuten, Durchbrüche und Löcher in den obersten Schichten erzeugt werden, die einen Kontakt mit den unteren Schichten erlauben.

Als "Sputtern" oder als "Aufdampfen" wird die übliche Technik bezeichnet, mit der Schichten auf elektronische und elektrische Bauelemente aufgebracht werden.

Im folgenden wird der Aufbau eines erfindungsgemäßen Bauelements und das erfindungsgemäße Verfahren anhand einer bevorzugten Ausführungsform, gezeigt in den Figuren 1 bis 5, näher erläutert.

Figur 1 zeigt einen Querschnitt durch ein Bauelement zwischen zwei Verfahrensschritten, wie es auch in bekannten Verfahren intermediär entsteht.

Figur 2 zeigt denselben Querschnitt, nachdem in einem erfindungsgemäßen Verfahrensschritt ein strukturiertes Material, das als Untergrund für ein Lift-Off-Verfahren geeignet ist (schraffiert gezeichnet), aufgebracht wurde.

Figur 3 zeigt wiederum den Querschnitt, nachdem erfindungsgemäß über die oberste und strukturierte Schicht (schraffiert) ein Isolator (mit kleinen Kringeln gekennzeichnet) aufgebracht wurde.

Figur 4 zeigt noch einmal den Querschnitt nach abgeschlossenem Lift-Off-Verfahren, mit der Isolierung der unteren Elektrode und vor Anbringung der oberen Elektrode, die nicht gezeigt wird.

Figur 5 zeigt das erfindungsgemäße Bauelement von oben in der Aufsicht

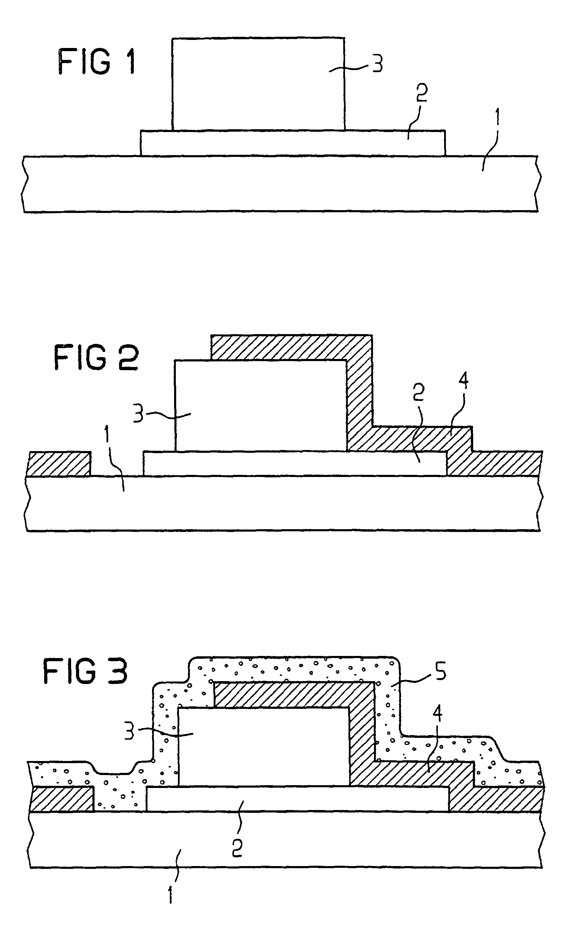

Figur 1 zeigt von unten nach oben gesehen zunächst das Substrat 1, beispielsweise monokristallines Silizium, auf dem die untere Elektrode 2 nach dem Strukturierungsschritt für die ferroelektrische Schicht 3 strukturiert und die darauffolgende Schicht 3, nämlich die ferroelektrisch aktive Schicht 3, aufgebracht wurde. Dieser Zustand des Bauelements wird auch nach den üblichen Methoden zur Herstellung von Bauelementen, wie beispielsweise von Pyrodetektoren, erreicht.

Figur 2 zeigt die erfindungsgemäße Aufbringung des, als Untergrund für das Lift-Off-Verfahren geeigneten, Materials. Das geeignete Material, das erfindungsgemäß strukturiert aufgebracht wurde, ist schraffiert eingezeichnet. Es ist überall dort auf dem Bauelement aufgebracht, wo sich im Endergebnis kein isolierendes Material befinden soll. Die Schicht aus dem Material 4, das für den Lift-Off-Untergrund geeignet ist, beispielsweise einem Photolack, ist schraffiert gezeichnet. Sie bedeckt teilweise das Substrat 1, die untere Elektrode 2, soweit sie im späteren Verfahren nicht mit der oberen Elektrode (nicht gezeigt) oder deren Anschlußleitungen in Berührung kommen soll und sie bedeckt zum großen Teil die ferroelektrisch aktive Schicht, nämlich entlang der Flächen und Kanten, wo im späteren Verfahrensschritt die obere Elektrode mit der ferroelektrisch aktiven Schicht 3 direkt zusammentreffen soll, ohne daß Isolierung dazwischen ist.

Figur 3 zeigt das Bauelement nach dem auf die Untergrundschicht des Lift-Off-Verfahrens 4, also auf z. B. den Photolack, eine isolierende Schicht 5 unstrukturiert, d.h. die ganze Oberfläche des Bauelements bedeckend, aufgebracht ist. Die isolierende Schicht 5 ist mit lauter kleinen Kringeln gezeichnet. Es ist gut zu erkennen, daß die isolierende Schicht nur dort die Oberfläche des Bauelements berühren kann, wo zuvor die exemplarisch genannte Photolackschicht weggeätzt, d.h. durch Strukturieren entfernt, wurde. Diese Stellen sind diejenigen, die später isoliert sein sollen.

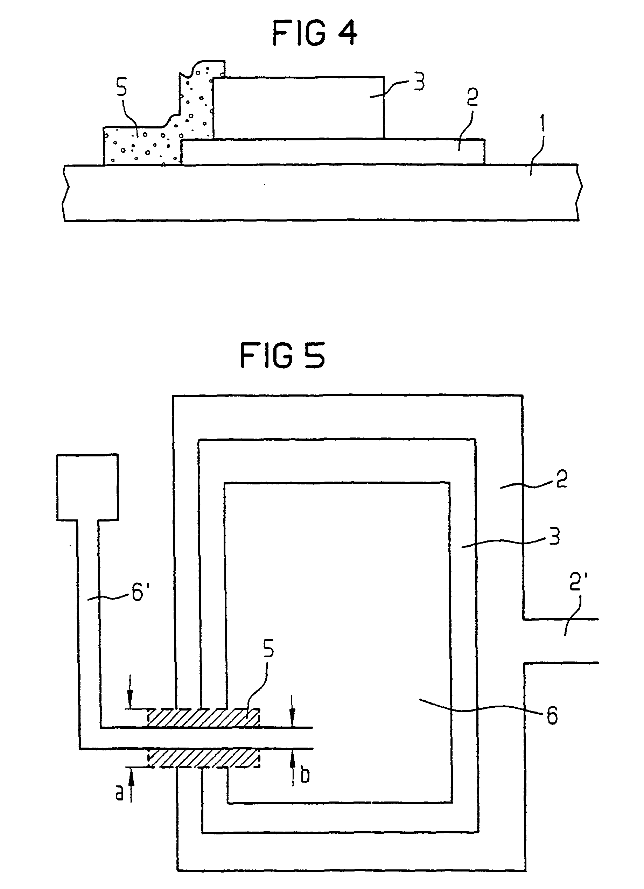

Figur 4 zeigt das erfindungsgemäße Verfahren, nachdem der Lift-Off-Verfahrensteilschritt stattgefunden hat, d.h. es zeigt das Bauelement entsprechend der Figur 1, wobei die Teile des Bauelements, die vor direktem Kontakt mit der im nachfolgenden Verfahrensschritt aufzubringenden oberen Elektrode (nicht gezeigt) geschützt werden sollen, weil beispielsweise ein Kurzschluß zu erwarten wäre, durch isolierendes Material 5, das mit kleinen Kringeln gezeichnet ist, abgedeckt sind.

Figur 5 zeigt eine Aufsicht auf das Bauelement. Die oberste, gezeigte Schicht ist die obere Elektrode 6 und die Leiterbahn 6' der oberen Elektrode, die ihren Anschluß an beispielsweise ein Element des Ausleseschaltkreises ermöglicht. Weiterhin ist der Randbereich der ferroelektrisch aktiven Schicht 3, also beispielsweise des PZT, und der Randbereich der unteren Elektrode 2 mit daran anschließender Leiterbahn 2'zu sehen. Die Erfindung betrifft die seitliche Isolierung der Leiterbahn 6' der oberen Elektrode gegenüber der unteren Elektrode 2 und der ferroelektrisch aktiven Schicht 3. Die Breite a der isolierenden Schicht ist so gewählt, daß sie unter Berücksichtigung der Justierungsungenauigkeiten der Photolithographie einen Kontakt der Leiterbahn 6'zur ferrolektrisch aktiven Schicht 3 und vor allem zur unteren Elektrode 2 sicher verhindert. Die Leiterbahnen haben typische Breiten b von b = 1 bis 10 µm, mit anderen Worten genügt auch bei breiten Leiterbahnen eine Breite a = 20 µm der isolierenden Schicht 5. Diese schmale Ausführung der isolierenden Schicht 5 ist günstig für die elektrischen Eigenschaften des Detektorelements, weil die thermische" Masse so minimal gehalten werden kann.

Nachdem erfindungsgemäßen Verfahren ist es also kein Problem, die obere Elektrode über die gesamte Oberfläche des Bauelementes aufzubringen und es müssen keine Kurzschlüsse, die durch Kontakte der unteren mit der oberen Elektrode entstehen könnten, befürchtet werden. Das erfindungsgemäße Verfahren bietet die Vorteile, daß es bei niedrigen Temperaturen und in einfacher Weise durchgeführt werden kann und daß dank der niedrigen Temperaturen und der beim Aufsputtern des isolierenden Materials bestehenden sauerstoffreichen Atmosphäre keine Beschädigungen der ferroelektrischen Aktivität der, das Zentrum des Pyrodetektors oder des Bauelementes bildenden, ferroelektrisch aktiven Schicht, zu erwarten sind.

Der erfindungsgemäße Prozeßschritt der Isolation der oberen von der unteren Elektrode beispielsweise eines pyroelektrischen Kondensators könnte sich als Schlüsselschritt bei der Herstellung von IR-Detektorarrays mit ferroelektrischen Dünnschichten erweisen.

## Patentansprüche

1. Ferroelektrisches Bauelement, das aufeinanderfolgend Substrat (1), eine untere Elektrode (2), eine ferroelektrisch aktive Schicht (3), eine Schicht (5) aus isolierendem Material und eine obere Elektrode (6) umfaßt, **dadurch gekennzeichnet, daß** die Schicht (5) aus isolierendem Material ein Oxid, ausgewählt aus der Reihe der zwei- und dreiwertigen anorganischen Oxide oder Mischoxide, ist.

2. Bauelement nach Anspruch 1, bei dem das Oxid ein Oxid oder ein Mischoxid, ausgewählt aus der Reihe Aluminiumoxid, Magnesiumoxid und/oder Titanoxid, ist.

3. Verfahren zur Herstellung von ferroelektrischen Bauelementen, bei dem nacheinander folgende Schichten auf ein Substrat (1) gebracht werden:
- eine untere Elektrode (2),
- auf die untere Elektrode (2) eine ferroelektrisch aktive Schicht (3),
- auf die ferroelektrisch aktive Schicht ein Material, das als Untergrund (4) für ein Lift-Off-Verfahren geeignet ist, wobei dieses Material so strukturiert wird, daß die Stellen, die gegenüber der oberen Elektrode (6) zu isolieren sind, frei von dem Material bleiben,
- über die Oberfläche des soweit bestehenden, also unfertigen Bauelements eine Schicht (5) aus isolierendem Material, das nach einem darauffolgenden Lift-Off-Verfahrensschritt nur an den Stellen des unfertigen Bauelements, an denen zuvor kein Lift-Off-Untergrund-Material war, bestehen bleibt und schließlich
- eine obere Elektrode (6).

4. Verfahren nach Anspruch 3, bei dem das isolierende Material durch Sputtern oder Aufdampfen aufgebracht wird.

5. Verfahren nach Anspruch 3 oder 4, bei dem das isolierende Material Aluminium- und/oder Magnesium- und/oder Titanoxid ist.

6. Verfahren nach einem der vorstehenden Ansprüche 3 bis 5, bei dem die ferroelektrisch aktive Schicht aus Bleizirkonattitanat, genannt PZT, besteht.

7. Verfahren nach einem der vorstehenden Ansprüche 3 bis 6, bei dem das Material, das als Untergrund für das Lift-Off-Verfahren dient, ein Photolack ist.

8. Anwendung des Verfahrens nach einem der Ansprüche 3 bis 7 bei der Herstellung von Pyrodetektor-Arrays.

9. Anwendung des Verfahrens nach einem der Ansprüche 3 bis 7 bei der Herstellung von Kondensator-Arrays.

## Claims

1. Ferroelectric device, that successively comprises a substrate (1), a lower electrode (2), a ferroelectrically active layer (3), a layer (5) made of insulating material and an upper electrode (6), **characterized in that** the layer (5) made of insulating material is an oxide selected from the series of bivalent and trivalent inorganic oxides or composite oxides.

2. Device according to Claim 1, with which the oxide is an oxide or composite oxide, selected from the series aluminum oxide, magnesium oxide and/or titanium oxide.

3. Method for fabricating ferroelectric devices, with which successive layers are applied to a substrate (1):
- a lower electrode (2),
- a ferroelectrically active layer (3) on the lower electrode (2),
- a material, which is suitable as a base (4) for a lift-off method on the ferroelectrically active layer, whereby said material is structured so that the areas to be insulated from the upper electrode are free of material,
- over the surface of the thus far existing, i.e. unfinished, device a layer (5) made of insulating material, which after a subsequent lift-off method stage only remains on those areas of the unfinished device, at which there was previously no lift-off base material and finally,
- an upper electrode (6).

4. Method according to Claim 3, with which the insulating material is applied by sputtering or vapor-depositing.

5. Method according to Claim 3 or 4, with which the insulating material is aluminum and/or magnesium and/or titanium oxide.

6. Method according to one of the preceding Claims 3 to 5, with which the ferroelectrically active layer is made of lead zirconate titanate, known as PZT.

7. Method according to one of the preceding Claims 3 to 6, with which the material used as a base for the lift-off method is a photo-resist.

8. Application of a method according to one of Claims 3 to 7 during the fabrication of pyrodetector arrays.

9. Application of a method according to one of Claims 3 to 7 during the fabrication of capacitor arrays.

## Revendications

1. Composante ferroélectrique, comprenant consécutivement un substrat (1), une électrode inférieure (2), une couche ferroélectrique active (3), une couche (5) en matériau isolant et une électrode supérieure (6), **caractérisée en ce que** la couche (5) en matériau isolant est un oxyde, choisi dans la série des oxydes anorganiques ou des oxydes mixtes bivalents et trivalents.

2. Composante selon la revendication 1, dans laquelle l'oxyde est un oxyde ou un oxyde mixte, choisi dans la série de l'oxyde d'aluminium, de l'oxyde de magnésium et/ou de l'oxyde de titane.

3. Procédé pour la fabrication de composantes ferroélectriques, au cours duquel, on applique consécutivement les couches suivantes sur un substrat (1) :
- une électrode inférieure (2),
- sur l'électrode inférieure (2), une couche ferroélectrique active (3),
- sur la couche ferroélectrique active, un matériau, qui est adapté pour servir de sous-couche (4) pour un procédé lift-off, ce matériau étant structuré de façon à ce que les endroits devant être isolés par rapport à l'électrode supérieure (6) restent exempts de matériau,
- sur la surface de la composante en l'état actuel, non donc finie, une couche (5) d'un matériau isolant, qui à l'issue d'une étape consécutive du procédé lift-off ne subsiste que sur les endroits de la composante non finie, sur lesquels aucun matériau de sous-couche pour le procédé lift-off ne se trouvait et finalement
- une électrode supérieure (6).

4. Procédé selon la revendication 3, dans lequel le matériau isolant est appliqué par dépôt par pulvérisation ou par vaporisation.

5. Procédé selon l'une quelconque des revendications 3 ou 4, dans lequel le matériau isolant est de l'oxyde d'aluminium et/ou de l'oxyde de magnésium et/ou de l'oxyde de titane.

6. Procédé selon l'une quelconque des revendications 3 à 5, dans lequel la couche ferroélectrique active est constituée de titanate-zirconate de plomb, dénommé PZT.

7. Procédé selon l'une quelconque des revendications précédentes 3 à 6, dans lequel le matériau servant de sous-couche pour le procédé lift-off est une laque photosensible.

8. Utilisation du procédé selon l'une quelconque des revendications 3 à 7 pour la fabrication d'arrangements de pyrodétecteurs.

9. Utilisation du procédé selon l'une quelconque des revendications 3 à 7 pour la fabrication d'arrangements de condensateurs.
